# EUROPEAN PATENT APPLICATION

(11) **EP 4 679 965 A1**
(43) Date of publication of application: **14.01.2026**
(21) Application number: 25187906.0
(22) Date of filing: 07.07.2025
(51) Int. Cl.: H10B 10/00, H10D 30/47, H10D 88/00

(54) **STATIC RANDOM-ACCESS MEMORY DEVICE HAVING MONOLITHIC 3D STACK STRUCTURE AND ELECTRONIC APPARATUS INCLUDING THE STATIC RANDOM-ACCESS MEMORY DEVICE**

(30) Priority: 10.07.2024 KR 20240091327
(71) Applicant: SAMSUNG ELECTRONICS CO., LTD., Yeongtong-gu Suwon-si, Gyeonggi-do 16677 (KR); Seoul National University R&DB Foundation, Seoul 08826 (KR)
(72) Inventor: KIM, Joonseok, 16678 Suwon-si (KR); KIM, Munhyeon, 08826 Seoul (KR); KIM, Jaejoon, 08826 Seoul (KR); KWON, Junyoung, 16678 Suwon-si (KR); KIM, Sangwon, 16678 Suwon-si (KR); RYU, Huije, 16678 Suwon-si (KR); KIM, Joonyun, 16678 Suwon-si (KR); SHIM, Jaewoo, 16678 Suwon-si (KR); LEE, Changeseok, 16678 Suwon-si (KR); JANG, Hyeongseok, 16678 Suwon-si (KR); HU, Luhing, 16678 Suwon-si (KR)
(74) Representative: Elkington and Fife LLP

(57) **Abstract**

Provided are a static random-access memory (SRAM) device having a monolithic three-dimensional stack structure and an electronic apparatus including the SRAM device. The SRAM device includes a first tier including first and second transistors, a second tier stacked on the first tier and including third and fourth transistors, and a third tier stacked on the second tier and including fifth and sixth transistors. Each of the first to sixth transistors includes a channel layer including a two-dimensional semiconductor material. A gate of at least one of the fifth and sixth transistors is arranged to intersect a gate of at least one of the first to fourth transistors.

## Description

### FIELD OF THE INVENTION

Some example embodiments relate to a static random-access memory (SRAM) device having a monolithic three-dimensional stack structure and/or an electronic apparatus including the SRAM device.

### BACKGROUND OF THE INVENTION

Semiconductor devices have been down-scaled at a fast pace. Furthermore, as semiconductor devices expect to operate not only at fast operation speed, but also expect accuracy in operation, and the structure of transistors included in semiconductor devices has been improved. Static random-access memory (SRAM) devices are semiconductor devices that occupy a large proportion of a central processing unit (CPU), and to more efficiently perform a communication between a memory and the CPU, the degree of integration of SRAM devices may improve.

### SUMMARY OF THE INVENTION

Provided are a static random-access memory (SRAM) device having a monolithic three-dimensional stack structure and/or an electronic apparatus including the SRAM device.

Additional aspects will be set forth in part in the description which follows and, in part, will be apparent from the description, or may be learned by practice of the presented embodiments.

According to some example embodiments, an SRAM includes a first tier comprising first and second transistors, a second tier stacked on the first tier and comprising third and fourth transistors, and a third tier staked on the second tier and comprising fifth and sixth transistors, wherein each of the first to sixth transistors comprises a channel layer including a two-dimensional semiconductor material, and a gate of at least one of the fifth and sixth transistors is arranged to intersect a gate of at least one of the first to fourth transistors.

Alternatively or additionally according to some example embodiments, an SRAM device includes a first tier including first and second transistors, a second tier stacked on the first tier and including third and fourth transistors, and a third tier staked on the second tier and including fifth and sixth transistors, wherein each of the first to sixth transistors may include a channel layer including a two-dimensional semiconductor material, and a drain region of one of the fifth and sixth transistors may be electrically connected to a gate of one of the third and fourth transistors through a metal line provided in the second tier.

### BRIEF DESCRIPTION OF THE DRAWINGS

These and/or other aspects will become apparent and more readily appreciated from the following description of the embodiments, taken in conjunction with the accompanying drawings in which:
FIG. 1 is a schematic circuit diagram of a static random-access memory (SRAM) device according to some example embodiments:
FIG. 2 is a schematic cross-sectional of an SRAM device according to some example embodiments;
FIGS. 3A and 3B are plan layouts of a first tier illustrated in FIG. 2;
FIGS. 4A and 4B are plan layouts of a second tier illustrated in FIG. 2;
FIGS. 5A and 5B are plan layouts of a third tier illustrated in FIG. 2;
FIG. 6A is a cross-sectional view of the first and second tiers taken along line 1A'-1A' of FIG. 3A, line 1A"-1A" of FIG. 3B, line 2A'-2A' of FIG. 4A, and line 2A"-2A" of FIG. 4B;
FIG. 6B is a cross-sectional view of the first and second tiers taken along line 1B'-1B' of FIG. 3A, line 1B"-1B" of FIG. 3B, line 2B'-2B' of FIG. 4A, and line 2B"-2B" of FIG. 4B;
FIG. 7A is a cross-sectional view of the second and third tiers taken along line 2A'-2A' of FIG. 4A, line 2A"-2A" of FIG. 4B, line 3A'-3A' of FIG. 5A, and line 3A"-3A" of FIG. 5B;
FIG. 7B is a cross-sectional view of the second and third tiers taken along line 2B'-2B' of FIG. 4A, line 2B"-2B" of FIG. 4B, line 3B'-3B' of FIG. 5A, and line 3B"-3B" of FIG. 5B;
FIG. 8 is a perspective view of the first tier of FIG. 2;
FIGS. 9 and 10 are perspective views of the first tier and second tiers of FIG. 2;
FIGS. 11 and 12 are perspective views of the first tier, the second tier, and the third tier of FIG. 2; FIGS. 13A to 13F illustrate examples of a channel layer and a gate arranged in the first tier in an SRAM device according to some example embodiments; and
FIG. 14 is a schematic conceptual view of a device architecture applicable to an electronic apparatus according to some example embodiments.

### DETAILED DESCRIPTION

Reference will now be made in detail to some example embodiments, examples of which are illustrated in the accompanying drawings. In this regard, example embodiments may have different forms and should not be construed as being limited to the descriptions set forth herein. Accordingly, example embodiments are merely described below, by referring to the figures, to explain aspects. Expressions such as "at least one of," when preceding a list of elements, modify the entire list of elements and do not modify the individual elements of the list.

Hereinafter, example embodiments are described in detail with reference to the accompanying drawings. Throughout the drawings, like reference numerals denote like elements, and sizes of components in the drawings may be exaggerated for convenience of explanation and clarity. As embodiments described below are examples, other modifications may be produced from the embodiments.

When a constituent element is disposed "above" or "on" to another constituent element, the constituent element may include not only an element directly contacting on the upper, lower, left, and right sides of the other constituent element, but also an element disposed above, under, on the left side of, and on the right side of the other constituent element in a non-contact manner. As used herein, the singular forms "a," "an," and "the" are intended to include the plural forms as well, unless the context clearly indicates otherwise. Furthermore, it will be further understood that the terms "comprises" and/or "comprising" used herein specify the presence of stated features or elements, but do not preclude the presence or addition of one or more other features or elements.

The use of the terms "a," "an," "the," and similar referents in the context of describing the disclosure is to be construed to cover both the singular and the plural. Also, the operations of all methods described herein can be performed in any suitable order unless otherwise indicated herein or otherwise clearly contradicted by context. The disclosure is not limited to the described order of the steps.

Furthermore, terms such as "... portion," "... unit," "... module," and "... block" stated in the disclosure may signify a unit to process at least one function or operation and the unit may be embodied by hardware, software, or a combination of hardware and software.

Furthermore, the connecting lines, or connectors shown in the various figures presented are intended to represent functional relationships and/or physical or logical couplings between the various elements. It should be noted that many alternative or additional functional relationships, physical connections or logical connections may be present in a practical device.

The use of any and all examples, or language (e.g., "such as") provided herein, is intended merely to better illuminate the disclosure and does not pose a limitation on the scope of the disclosure unless otherwise claimed.

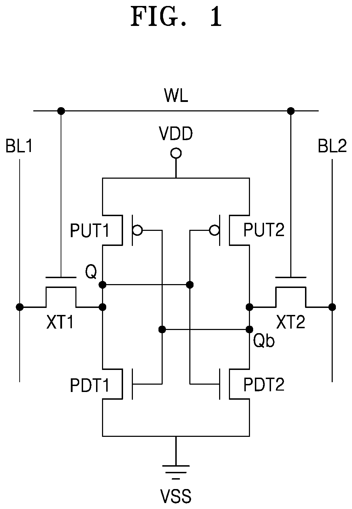

FIG. 1 is a schematic circuit diagram of a static random access memory (SRAM) device according to some example embodiments. FIG. 1 is a circuit diagram of one memory cell of a plurality of memory cells constituting an SRAM device.

Referring to FIG. 1, each memory cell of the SRAM device according to some example embodiments may include 6 (six) transistors. In detail, each memory cell of an SRAM device may include a first access transistor XT1, a second access transistor XT2, a first pull-up transistor PUT1, a second pull-up transistor PUT2, a first pull-down transistor PDT1, and a second pull-down transistor PDT2.

The first pull-up transistor PUT1 and the second pull-up transistor PUT2 may be formed as PMOS field effect transistors (PMOS FETs or PFETs), the first pull-down transistor PDT1 and the second pull-down transistor PDT2 may be formed as NMOS FETs, and the first access transistor XT1 and the second access transistor XT2 may be formed as NMOS FETs or NFETs. The first pull-up transistor PUT1 and the first pull-down transistor PDT1 may constitute (or be include in) a first CMOS invertor and act as at least a portion of a storage element. Furthermore, the second pull-up transistor PUT2 and the second pull-down transistor PDT2 may constitute (or be included in) a second CMOS invertor and act as at least a portion of the storage element, e.g., when cross-coupled with the first CMOS inverter. A supply voltage VDD may be connected to the first and second pull-up transistors PUT1 and PUT2, and a ground voltage VSS may be connected to the first and second pull-down transistors PDT1 and PDT2.

The first and second access transistors XT1 and XT2 may allow an access to the first and second CMOS invertors in data read and write operations, and may block an access to the first and second CMOS invertors during data holding. A first column line or first bit line BL1 may be connected to a drain of the first access transistor XT1, and a source of the first access transistor XT1 may be connected to gates of the second pull-up transistor PUT2 and the second pull-down transistor PDT2 through a first node Q. Furthermore, a second column line or second bit line BL2 may be connected to a drain of the second access transistor XT2, and a source of the second access transistor XT2 may be connected to gates of the first pull-up transistor PUT1 and the first pull-down transistor PDT1 through a second node Qb. A row line or a word line WL may be connected to gates of the first and second access transistors XT1 and XT2.

An SRAM device according to some example embodiments may have, as described below, a monolithic three-dimensional (3D) stack structure as the first and second pull-up transistors PUT1 and PUT2, the first and second pull-down transistors PDT1 and PDT2, and the first and second access transistors XT1 and XT2 are arranged in different tiers. For example, the SRAM device according to some example embodiments may be or include a 6T, or six-transistor, memory cell.

The electrical and/or physical properties of each of the transistors PUT1, PUT2, PDT1, PDT2, XT1, and XT2 may be set or determined based on an improvement of, e.g., an optimization of, various performances of the memory device. For example, various ratios such as various alpha, beta, and gamma ratios may be determined based on gate widths and/or drive currents of each of the transistors. The electrical and/or physical properties of each of the transistors may be varied and may be different from one another, in some cases.

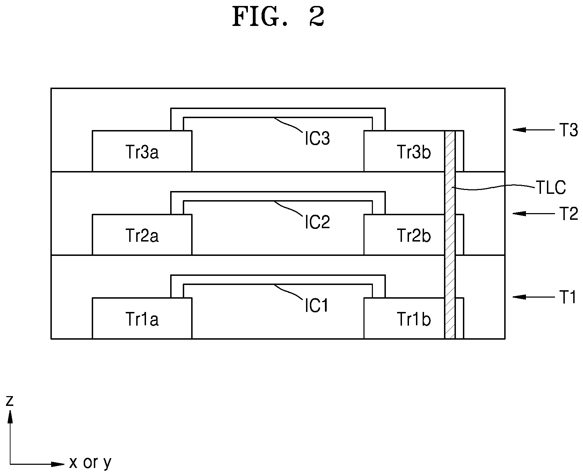

FIG. 2 is a schematic cross-sectional of an SRAM device according to some example embodiments. FIG. 2 is a schematic cross-sectional of one memory cell of a plurality of memory cells constituting an SRAM device.

Referring to FIG. 2, each memory cell of an SRAM device has a monolithic 3D stack structure formed as or comprising three tiers T1, T2, and T3 that are stacked. Each memory cell of an SRAM device may include three tiers, for example, the first, second, and third tiers T1, T2, and T3 stacked in a vertical direction (z-axis direction) stacked. In some example embodiments, there may not be a fourth tier stacked in the vertical direction; example embodiments are not limited thereto. Pairs of first and second transistors Tr1a and Tr1b, third and fourth transistors Tr2a and Tr2b, and fifth and sixth transistors Tr3a and Tr3b are arranged in the first, second, and third tiers T1, T2, and T3, respectively.

A pair of transistors, for example, the first and second transistors Tr1a and Tr1b, may be disposed in the first tier T1. The first and second transistors Tr1a and Tr1b may be arranged in a horizontal direction (x-axis direction or y-axis direction). The first and second transistors Tr1a and Tr1b may be electrically connected to each other in the first tier T1 by a first interconnect IC1. The first and second transistors Tr1a and Tr1b may each be, for example, a PFET. For example, the first transistor Tr1a may be the first pull-up transistor PUT1 in FIG. 1, and the second transistor Tr1b may be the second pull-up transistor PUT2.

The second tier T2 may be stacked on the first tier T1. The second tier T2 may include a pair of transistors, for example, the third and fourth transistors Tr2a and Tr2b. The third and fourth transistors Tr2a and Tr2b may be arranged in the horizontal direction (x-axis direction or y-axis direction). The third and fourth transistors Tr2a and Tr2b may be arranged parallel to the first and second transistors Tr1a and Tr1b. However, example embodiments are not limited thereto, and the third and fourth transistors Tr2a and Tr2b may be arranged perpendicular to the first and second transistors Tr1a and Tr1b, in a plan view. The third and fourth transistors Tr2a and Tr2b may be electrically connected to each other in the second tier T2 by a second interconnect IC2. The third and fourth transistors Tr2a and Tr2b may each be, for example, an NFET. For example, the third transistor Tr2a may be the first pull-down transistor PDT1 in FIG. 1, and the fourth transistor Tr2b may be the second pull-down transistor PDT2.

The third tier T3 is stacked on the second tier T2. The third tier T3 may include a pair of transistors, for example the fifth and sixth transistors Tr3a and Tr3b. The fifth and sixth transistors Tr3a and Tr3b may be arranged in the horizontal direction (x-axis direction or y-axis direction). The fifth and sixth transistors Tr3a and Tr3b may be arranged perpendicular to the third and fourth transistors Tr2a and Tr2b, in a plan view. However, example embodiments are not limited thereto, and the fifth and sixth transistors Tr3a and Tr3b may be arranged parallel to the third and fourth transistors Tr2a and Tr2b. The fifth and sixth transistors Tr3a and Tr3b may be electrically connected to each other in the third tier T3 by a third interconnect IC3. The fifth and sixth transistors Tr3a and Tr3b may each be, for example, an NFET. For example, the fifth transistor Tr3a may be the first access transistor XT1 in FIG. 1, and the sixth transistor Tr3b may be the second access transistor XT2.

Each of the first to sixth transistors Tr1a, Tr1b, Tr2a, Tr2b, Tr3a, and Tr3b may include a channel layer and in some example embodiments the channel layer may include a 2D (2D) semiconductor material. The 2D semiconductor material refers to a semiconductor material having a layered structure in which constituent atoms are two-dimensionally combined. The 2D semiconductor material may include, for example, transition metal dichalcogenide (TMD). However, example embodiments are not limited thereto. The TMD is a 2D material having semiconductor properties and is a compound of transition metal and a chalcogen element. The transition metal may include, for example, at least one of Mo, W, Nb, V, Ta, Ti, Zr, Hf, Co, Tc, and Re, and the chalcogen element may include, for example, at least one of S, Se, and Te. As a detailed example, the TMD may include MoS₂, MoSe₂, MoTe₂, WS₂, WSe₂, WTe₂, ZrS₂, ZrSe₂, HfS₂, HfSe₂, NbSe₂, or ReSe₂.

When the first and second transistors Tr1a and Tr1b arranged in the first tier T1 are PFETs, a channel layer of each of the first and second transistors Tr1a and Tr1b may include, for example, a p-type 2D semiconductor material (e.g., WSe₂). However, example embodiments are not limited thereto, and alternatively or additionally the channel layer of each of the first and second transistors Tr1a and Tr1b may include a 2D semiconductor material doped with a p-type dopant.

When the third and fourth transistors Tr2a and Tr2b arranged in the second tier T2 are NFETs, a channel layer of each of the third and fourth transistors Tr2a and Tr2b may include, for example, an n-type 2D semiconductor material (e.g., MoS₂). However, example embodiments are not limited thereto, and the channel layer of each of the third and fourth transistors Tr2a and Tr2b may alternatively or additionally include a 2D semiconductor material doped with an n-type dopant.

When the fifth and sixth transistors Tr3a and Tr3b arranged in the third tier T3 are NFETs, a channel layer of each of the fifth and sixth transistors Tr3a and Tr3b may include, for example, an n-type 2D semiconductor material (e.g., MoS₂). However, example embodiments are not limited thereto, and the channel layer of each of the fifth and sixth transistors Tr3a and Tr3b may alternatively or additionally include a 2D semiconductor material doped with an n-type dopant.

At least one inter-floor connection layer TLC that electrically connects the transistors arranged in the first, second, and third tiers T1, T2, and T3 different from one another may be provided in the first, second, and third tiers T1, T2, and T3. For example, the inter-floor connection layer TLC may electrically connect one of the first and second transistors Tr1a and Tr1b arranged in the first tier T1, one of the third and fourth transistors Tr2a and Tr2b arranged in the second tier T2, and the fifth and sixth transistors Tr3a and Tr3b arranged in the third tier T3, to one another. The inter-floor connection layer TLC may be configured as conductive members described below, such as one or more of metal lines, sources/drains, gates, and gate contacts, are electrically connected to one another.

A case in which the first and second transistors Tr1a and Tr1b arranged in the first tier T1 are PFETs, the third and fourth transistors Tr2a and Tr2b arranged in the second tier T2 are NFETs, and the fifth and sixth transistors Tr3a and Tr3b arranged in the third tier T3 are NFETs is described above. However, this is just an example, and one pair of the transistors Tr1a and Tr1b, Tr2a and Tr2b, and Tr3a and Tr3b respectively arranged in the first to third tiers T1, T2, and T3 may be, as necessary, PFETs or NFETs.

In the above descriptions, a case in which each memory cell of an SRAM device includes a total of six transistors Tr1a and Tr1b, Tr2a and Tr2b, and Tr3a and Tr3b is described. However, example embodiments are not limited thereto, and each memory cell may include more than six transistors (e.g., eight transistors) or fewer than six transistors (e.g., four transistors) to improve performance of an SRAM device or for the operation as an operator. In case the SRAM device includes more than six transistors, each memory cell may include more than three tiers (e.g., vertically stacked four tiers).

In the following description, a plan layout and a cross-section of each of the first, second, and third tiers T1, T2, and T3 constituting each memory cell of an SRAM device according to some example embodiments are described in detail. It is assumed that the first and second transistors Tr1a and Tr1b arranged in the first tier T1 are PFETs, the third and fourth transistors Tr2a and Tr2b arranged in the second tier T2 are NFETs, and the fifth and sixth transistors Tr3a and Tr3b arranged in the third tier T3 are NFETs. However, this is just an example.

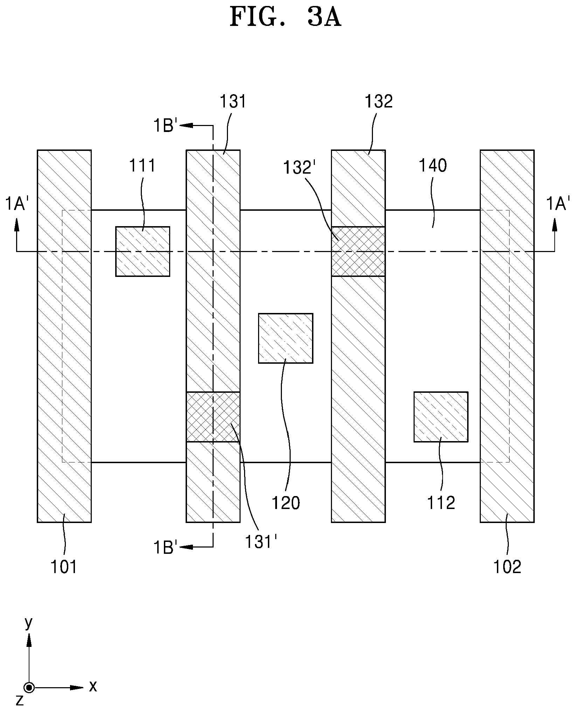

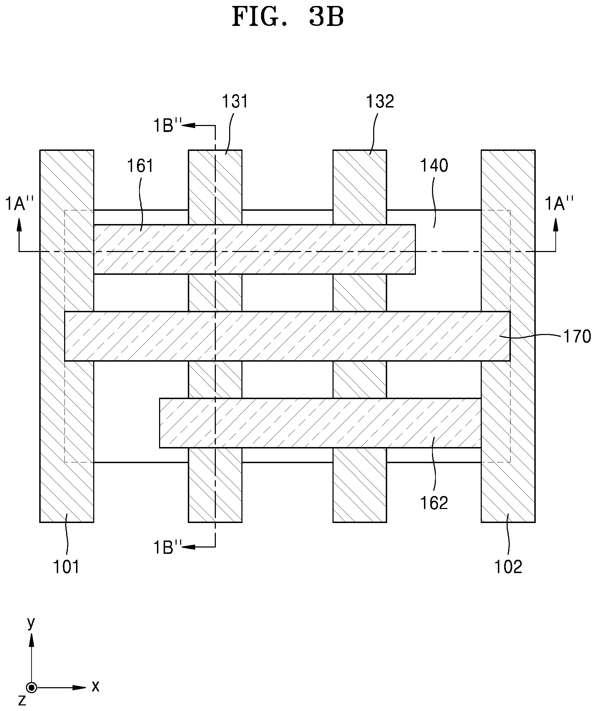

FIGS. 3A and 3B are plan layouts of the first tier T1 illustrated in FIG. 2. FIG. 3A is a plan layout of a lower portion of the first tier T1, and FIG. 3B is a plan layout of an upper portion of the first tier T1.

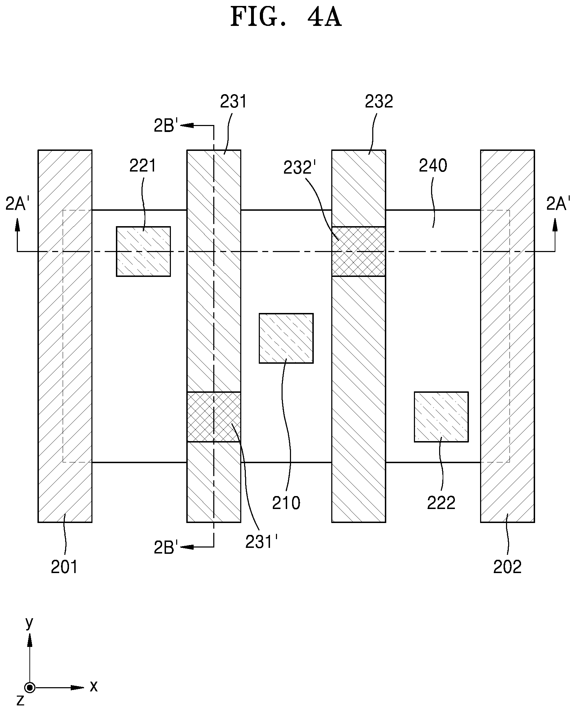

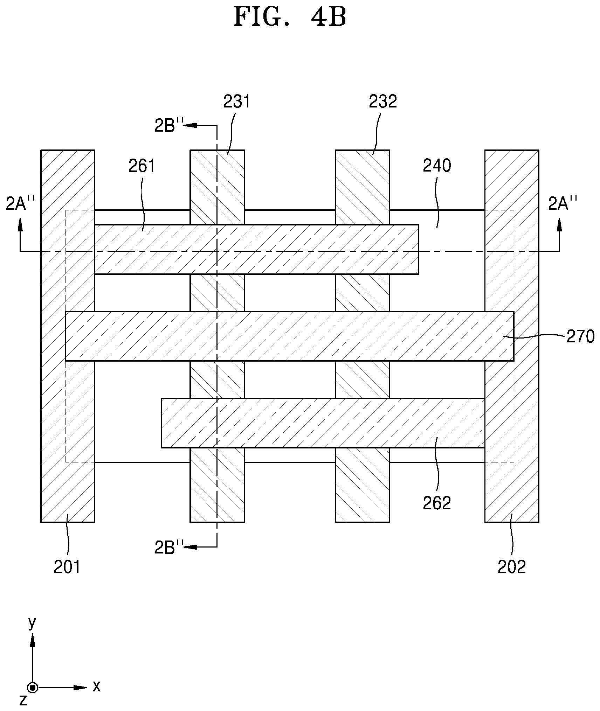

FIGS. 4A and 4B are plan layouts of the second tier T2 illustrated in FIG. 2. FIG. 4A is a plan layout of a lower portion of the second tier T2, and FIG. 4B is plan layout of an upper portion of the second tier T2.

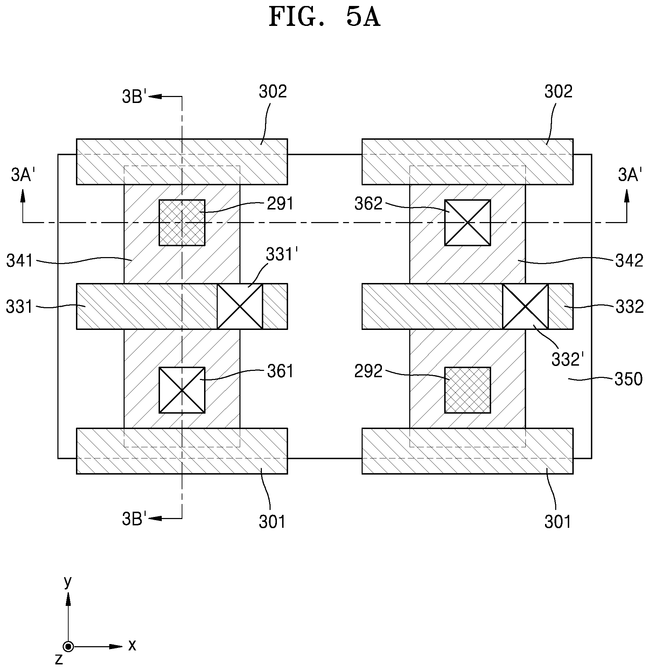

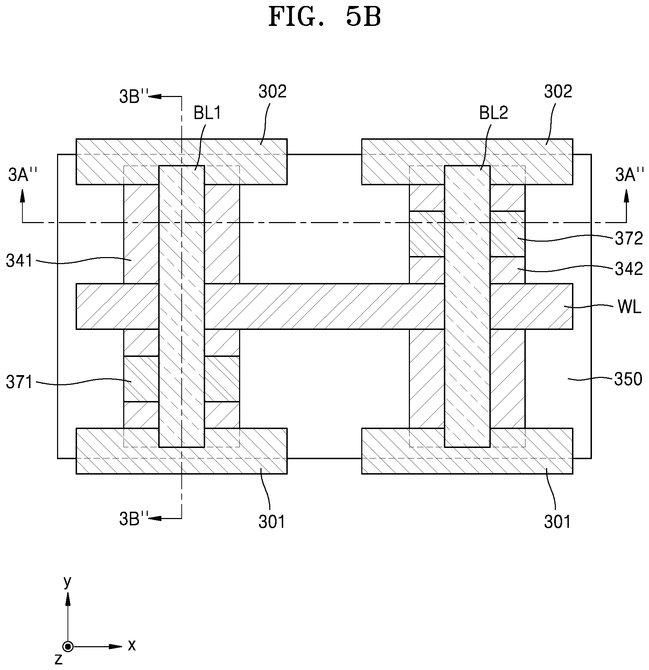

FIGS. 5A and 5B are plan layouts of the third tier T3 illustrated in FIG. 2. FIG. 5A is a plan layout of a lower portion of the third tier T3, and FIG. 5B is a plan layout of an upper portion of the third tier T3.

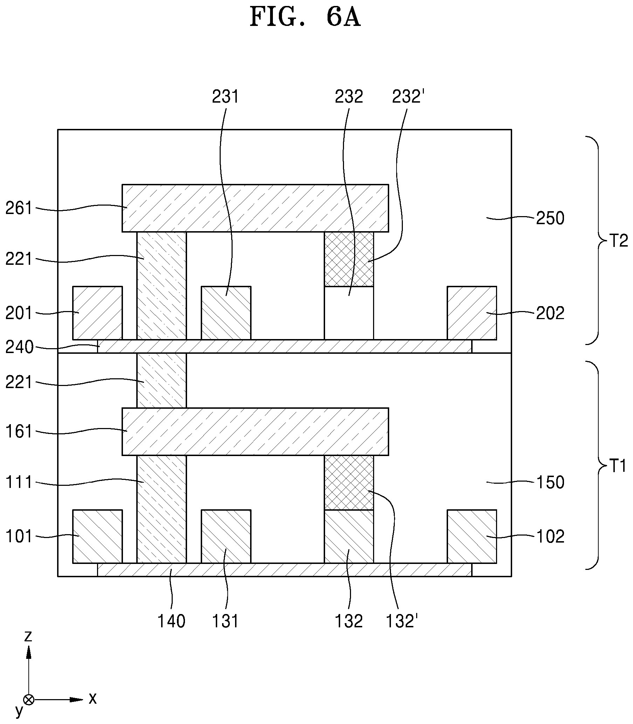

FIG. 6A is a cross-sectional view of the first and second tiers T1 and T2 taken along line 1A'-1A' of FIG. 3A (the lower portion of the first tier T1), line 1A"-1A" of FIG. 3B (the upper portion of the first tier T1), line 2A'-2A' of FIG. 4A (the lower portion of the second tier T2), and line 2A"-2A" of FIG. 4B (the upper portion of the second tier T2).

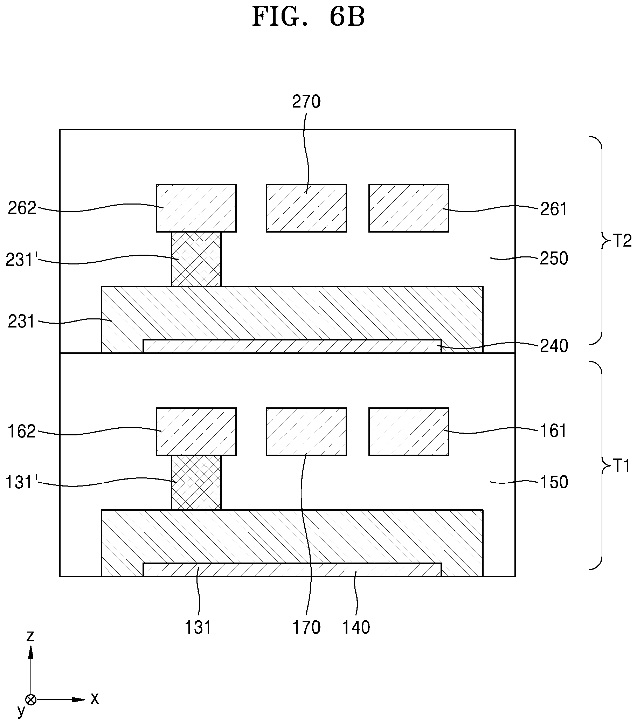

FIG. 6B is a cross-sectional view of the first and second tiers T1 and T2 taken along line 1B'-1B' of FIG. 3A (the lower portion of the first tier T1), line 1B"-1B" of FIG. 3B (the upper portion of the first tier T1), line 2B'-2B' of FIG. 4A (the lower portion of the second tier T2), and line 2B"-2B" of FIG. 4B (the upper portion of the second tier T2).

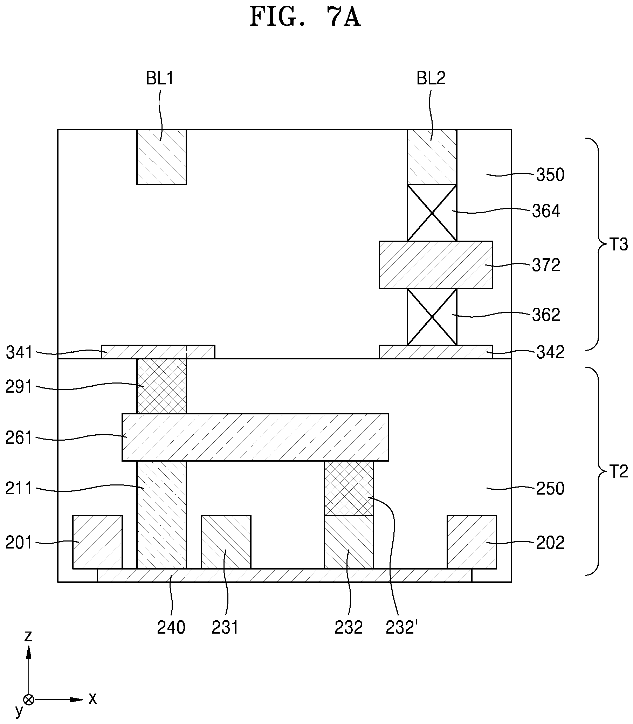

FIG. 7A is a cross-sectional view of the second and third tiers T2 and T3 taken along line 2A'-2A' of FIG. 4A (the lower portion of the second tier T2), line 2A"-2A" of FIG. 4B (the upper portion of the second tier T2), line 3A'-3A' of FIG. 5A (the lower portion of the third tier T3), and line 3A"-3A" of FIG. 5B (the upper portion of the third tier).

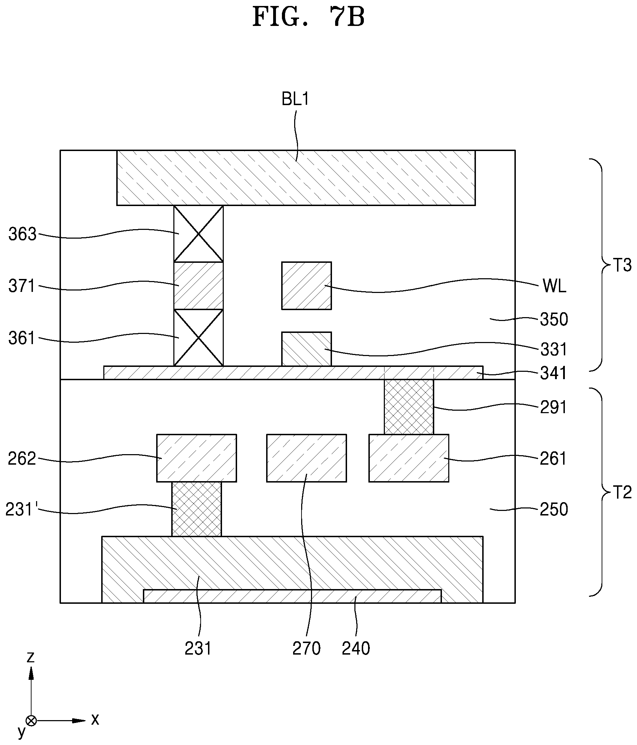

FIG. 7B is a cross-sectional view of the second and third tiers T2 and T3 taken along line 2B'-2B' of FIG. 4A (the lower portion of the second tier T2), line 2B"-2B" of FIG. 4B (the upper portion of the second tier T2), line 3B'-3B' of FIG. 5A (the lower portion of the third tier T3), and line 3B"-3B" of FIG. 5B (the upper portion of the third tier).

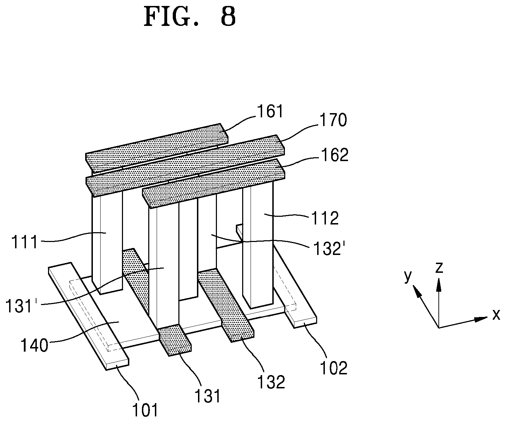

FIG. 8 is a perspective view of the first tier T1 of FIG. 2. FIG. 8 illustrates the lower and upper portions of the first tier T1.

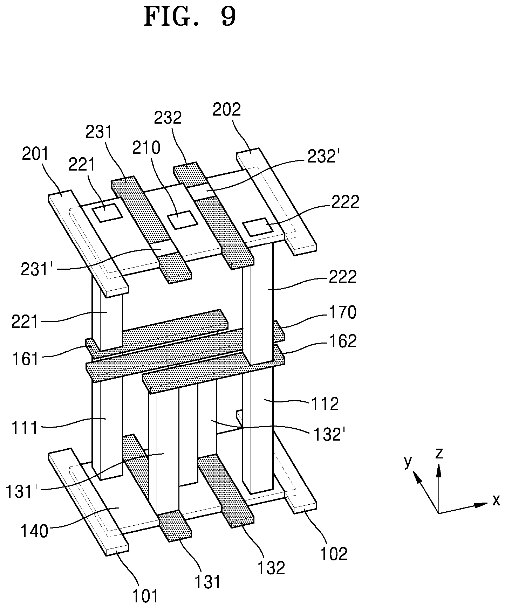

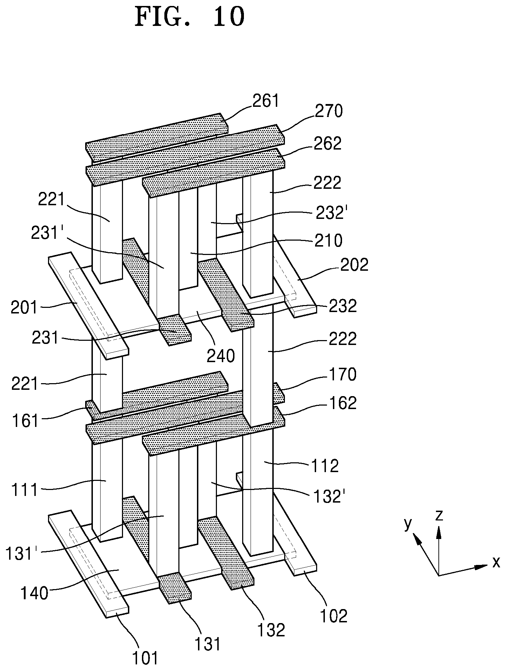

FIGS. 9 and 10 are perspective views of the first tier T1 and the second tier T2 of FIG. 2. FIG. 9 illustrates the lower portion of the second tier T2, and FIG. 10 illustrates the lower and upper portions of the second tier T2.

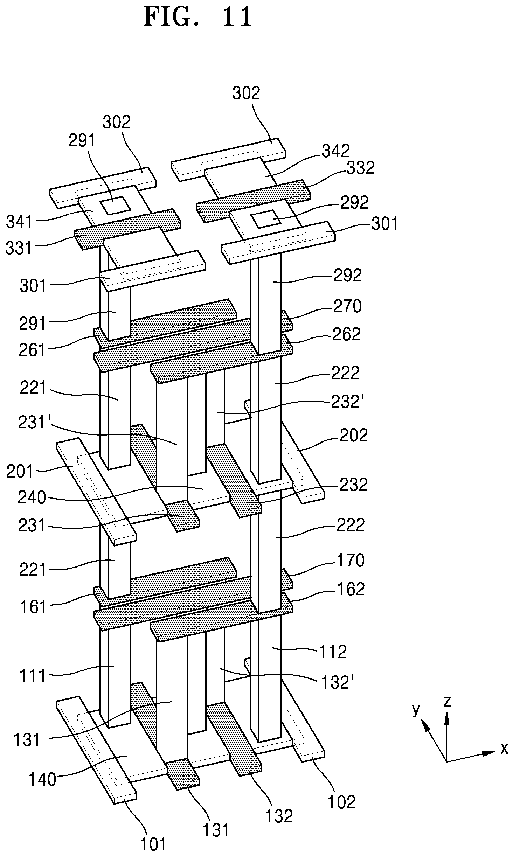

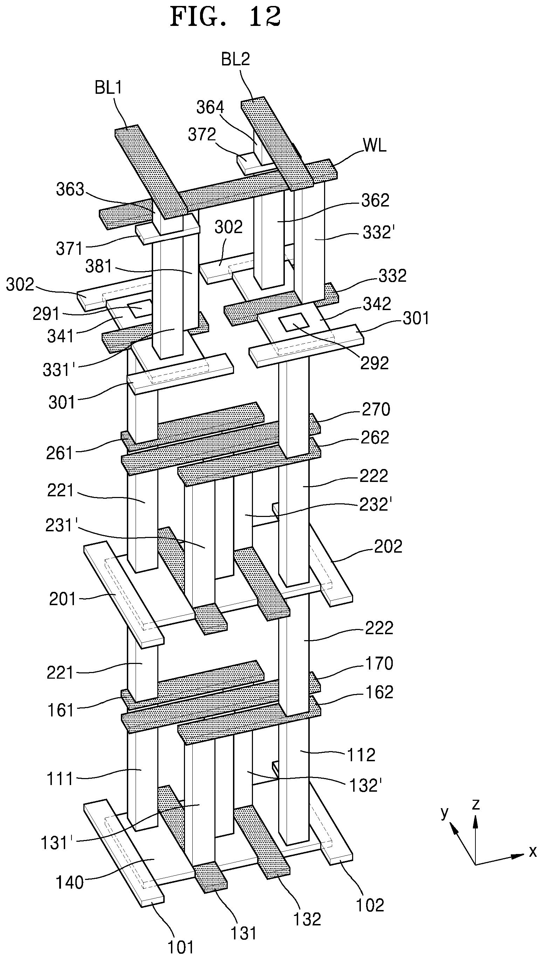

FIGS. 11 and 12 are perspective views of the first tier T1, the second tier T2, and the third tier T3. FIG. 11 illustrates the lower portion of the third tier T3, and FIG. 12 illustrates the lower and upper portions of the third tier T3.

Referring to FIGS. 3A, 6A, 6B, and 8, the first tier T1 may include a pair of transistors, for example, the first and second transistors Tr1a and Tr1b, between first and second isolation layers 101 and 102 for the separation of memory cells. The first and second transistors Tr1a and Tr1b may each be a PFET. For example, the first transistor Tr1a may be the first pull-up transistor PUT1 in FIG. 1, and the second transistor Tr1b may be the second pull-up transistor PUT2.

A first channel layer 140 may be provided between the first and second isolation layers 101 and 102. The first channel layer 140 may include a 2D semiconductor material. The 2D semiconductor material may include, for example, TMD, but the disclosure is not limited thereto. The first channel layer 140 may include, for example, a p-type 2D semiconductor material such as WSe₂. However, example embodiments are not limited thereto, and the first channel layer 140 may alternatively or additionally include the 2D semiconductor material doped with a p-type dopant. The first channel layer 140 may have a single-layer or multilayer structure.

First and second gates 131 and 132 may be provided apart from each other on an upper surface of the first channel layer 140. The first and second gates 131 and 132 may each extend in a first direction (y-axis direction) to cross the first channel layer 140. The first and second gates 131 and 132 may each include a metal material or a conductive oxide. The metal material may include, for example, at least one selected from the group consisting of Au, Ti, TiN, TaN, W, Mo, WN, Pt, and Ni, and the conductive oxide may include, for example, indium tin oxide (ITO), or indium zinc oxide (IZO). However, this is just an example.

A first gate contact 131' may be further provided at a certain position on an upper surface of the first gate 131, and a second gate contact 132' may be further provided at a certain position on an upper surface of the second gate 132. The first and second gate contacts 131' and 132' may include a material that is electrically conductive.

A first source 111 may be provided on the upper surface of the first channel layer 140 between the first isolation layer 101 and the first gate 131, and a second source 112 may be provided on the upper surface of the first channel layer 140 between the second isolation layer 102 and the second gate 132. A drain 120 may be provided on the upper surface of the first channel layer 140 between the first and second gates 131 and 132. In this state, the drain 120 may be shared by the first and second transistors Tr1a and Tr1b. The first and second sources 111 and 112 and the drain 120 may each include a material that is electrically conductive.

Referring to FIGS. 3B, 6A, 6B, and 8, a first metal line 161 is connected to upper surfaces of the first source 111 and the second gate contact 132', and a second metal line 162 is connected to upper surfaces of the second source 112 and the first gate contact 131'. The first and second metal lines 161 and 162 may each extend in a second direction (x-axis direction). A supply voltage line 170 is connected to an upper surface of the drain 120, and the supply voltage line 170 may extend in the second direction (x-axis direction). A first insulating layer 150 may be provided in the first tier T1 to cover the first and second transistors Tr1a and Tr1b.

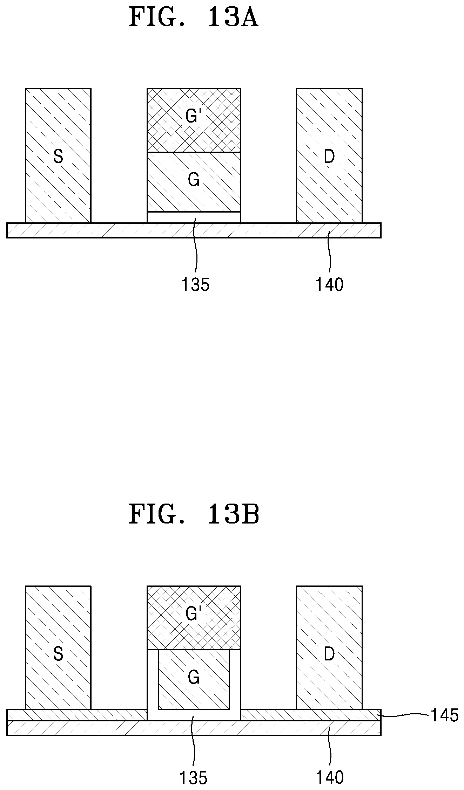

The first channel layer 140 and the first and second gates 131 and 132 in the first tier T1 may be modified in various ways. FIGS. 13A to 13F illustrate examples of the first channel layer 140 and the first and second gates 131 and 132 in the first tier T1. In FIGS. 13A to 13F, a source S denotes the first source 111 or the second source 112, and a drain D denotes the drain 120. A gate G denotes the first gate 131 or the second gate 132, and a gate contact G' denotes the first gate contact 131' or the second gate contact 132'.

Referring to FIG. 13A, the source S and the drain D may be provided on both sides of the upper surface of the first channel layer 140, and the gate G may be provided on the upper surface of the first channel layer 140 between the source S and the drain D. The first channel layer 140 may include a channel region located under the lower portion of the gate G and a source region in contact with the source S and a drain region in contact with the drain D. A gate insulating layer 135 may be provided between the first channel layer 140 and the gate G, and the gate contact G' may be provided on an upper surface of the gate G. The first channel layer 140 may include a 2D semiconductor material having a single-layer structure or a multilayer structure.

Referring to FIG. 13B, a contact metal layer 145 may be formed on the upper surface of the first channel layer 140 excluding the channel region of the first channel layer 140. The contact metal layer 145 may reduce contact resistance between the first channel layer 140 and each of the source S and the drain D.

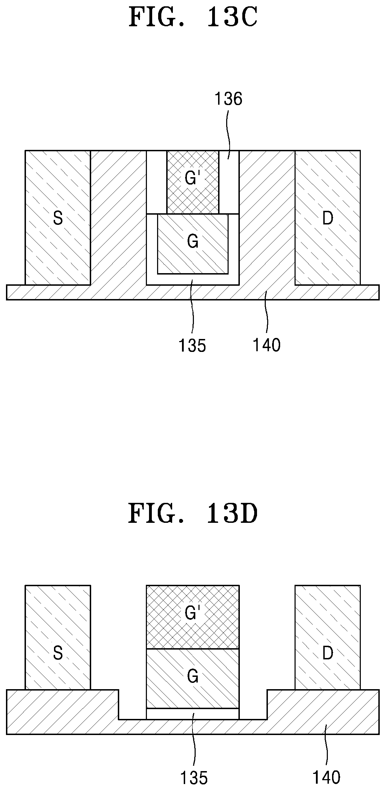

Referring to FIG. 13C, the channel region of the first channel layer 140 located under the gate G may include a 2D semiconductor material in a single layer. As a gap between the gate G and each of the source S and the drain D is filled with the 2D semiconductor material, a contact area between each of the source S and the drain D and the first channel layer 140 may increase. The gate insulating layer 135 may be provided around the gate G, and a gate contact insulating layer 136 may be provided around the gate contact G'.

Referring to FIG. 13D, the channel region of the first channel layer 140 located under the gate G may include a 2D semiconductor material in a single layer. In the first channel layer 140, a source region in contact with the source S and a drain region in contact with the drain D may include a 2D semiconductor material in a multilayer. When the 2D semiconductor material is formed in a multilayer, due to a decrease in bandgap, contact resistance between the source region of the first channel layer 140 and the source S and contact resistance between the drain region of the first channel layer 140 and the drain D may be reduced.

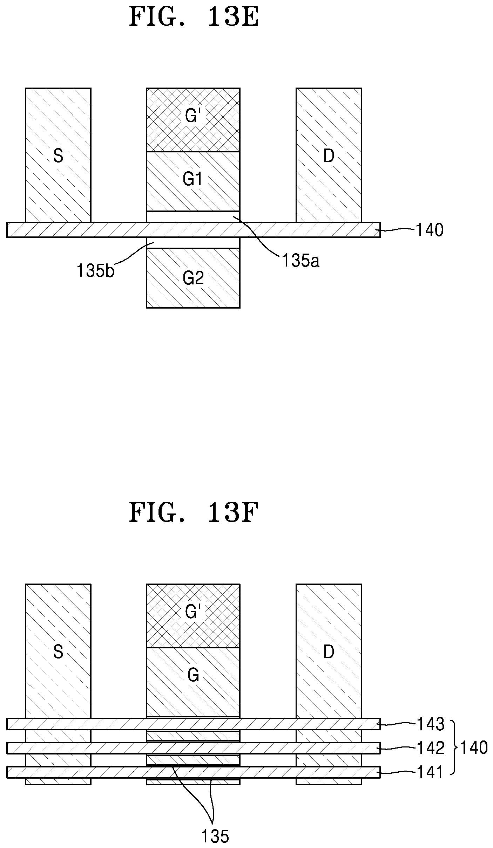

Referring to FIG. 13E, the first and second gates G1 and G2 may be provided around the first channel layer 140 between the source S and the drain D. In detail, the first gate G1 may be provided above the first channel layer 140, and the second gate G2 may be provided under the first channel layer 140. As such, as the first and second gates G1 and G2 may be provided respectively above and under the first channel layer 140, a gating effect may be improved. A first gate insulating layer 135a may be provided between the first channel layer 140 and the first gate G1, and a second gate insulating layer 135b may be provided between the first channel layer 140 and the second gate G2.

Referring to FIG. 13F, the first channel layer 140 may include a plurality of channel layers 141, 142, and 143 which are vertically apart from one another. The plurality of channel layers 141, 142, and 143 may each include a 2D semiconductor material. The gate G may surround the plurality of channel layers 141, 142, and 143, and the gate insulating layer 135 may be provided between each of the plurality of channel layers 141, 142, and 143 and the gate G. The source S and the drain D may be provided on the plurality of channel layers 141, 142, and 143 on both sides of the gate G.

Referring to FIGS. 4A, 6A, 6B, 9, and 10, the second tier T2 may include a pair of transistors, that is, the third and fourth transistors Tr2a and Tr2b, arranged between third and fourth isolation layers 201 and 202. The third and fourth transistors Tr2a and Tr2b may each be an NMOS FET. For example, the third transistor Tr2a may be the first pull-down transistor PDT1 in FIG. 1, and the fourth transistor Tr2b may be the second pull-down transistor PDT2.

A second channel layer 240 may be provided between the third and fourth isolation layers 201 and 202. The second channel layer 240 may include a 2D semiconductor material. The 2D semiconductor material may include, for example, TMD, but example embodiments are not limited thereto. The second channel layer 240 may include, for example, an m-type 2D semiconductor material such as MoS₂. However, example embodiments are not limited thereto, and the second channel layer 240 may include a 2D semiconductor material doped with an n-type dopant. The second channel layer 240 may have a single-layer or multilayer structure.

Third and fourth gates 231 and 232 may be provided apart from each other on an upper surface of the second channel layer 240. The third and fourth gates 231 and 232 may each extend in the first direction (y-axis direction) to intersect the second channel layer 240. The third and fourth gates 231 and 232 may each include a metal material and/or a conductive oxide. A third gate contact 231' may be further provided at a certain position on an upper surface of the third gate 231, and a fourth gate contact 232' may be further provided at a certain position on an upper surface of the fourth gate 232. The third and fourth gates contacts 231' and 232' may each include a material that is electrically conductive.

A first drain 221 may be provided on the second channel layer 240 between the third isolation layer 201 and the third gate 231, and a second drain 222 may be provided on the second channel layer 240 between the fourth isolation layer 202 and the fourth gate 232. The first drain 221 may pass through the second channel layer 240 to be connected to the first metal line 161 arranged in the first tier T1. Accordingly, a source region of the first transistor Tr1a in the first tier T1 and a drain region of the third transistor Tr2a in the second tier T2 may be electrically connected to each other through the first source 111 of the first transistor Tr1a, the first metal line 161, and the first drain 221 of the third transistor Tr2a. The second drain 222 may pass through the second channel layer 240 to be connected to the second metal line 162 in the first tier T1. Accordingly, a source region of the second transistor Tr1b in the first tier T1 and a drain region of the fourth transistor Tr2b in the second tier T2 may be electrically connected to each other through the second source 112 of the second transistor Tr1b, the second metal line 162, and the second drain 222 of the fourth transistor Tr2b.

A source 210 may be provided on the upper surface of the second channel layer 240 between the third and fourth gates 231 and 232. The source 210 may be shared by the third and fourth transistors Tr2a and Tr2b. The first and second drains 221 and 222 and the source 210 may include a material that is electrically conductive.

Referring to FIGS. 4B, 6A, 6B, 9, and 10, a third metal line 261 is connected to upper surfaces of the first drain 221 and the fourth gate contact 232', and a fourth metal line 262 is connected to upper surfaces of the second drain 222 and the third gate contact 231'. The third and fourth metal lines 261 and 262 may each extend in the second direction (x-axis direction). The first and third metal lines 161 and 261 may be electrically connected to each other by the first drain 221 that passes through the second channel layer 240. The second and fourth metal lines 162 and 262 may be electrically connected to each other by the second drain 222 that passes through the second channel layer 240. A ground voltage line 270 is connected to an upper surface of the source 120, and the ground voltage line 270 may extend in the second direction (x-axis direction). A second insulating layer 250 may be provided in the second tier T2 to cover the third and fourth transistors Tr2a and Tr2b. The second channel layer 240 and the third and fourth gates 231 and 232 in the second tier T2 may be modified in various ways similar to the illustrations in FIGS. 13A to 13F.

Referring to FIGS. 5A, 7A, 7B, 11, and 12, the third tier T3 may include a pair of transistors, for example, the fifth and sixth transistors Tr3a and Tr3b, arranged between fifth and sixth isolation layers 301 and 302. The fifth and sixth transistors Tr3a and Tr3b may each be an NMOS FET. For example, the fifth transistor Tr3a may be the first access transistor XT1 in FIG. 1, and the sixth transistor Tr3b may be the second access transistor XT2. The fifth and sixth transistors Tr3a and Tr3b in the third tier T3 may be provided perpendicular to the third and fourth transistors Tr2a and Tr2b in the second tier T2, in a plan view.

The third and fourth channel layers 341 and 342 may be provided apart from each other between the fifth and sixth isolation layers 301 and 302. The third and fourth channel layers 341 and 342 may include a 2D semiconductor material. The third and fourth channel layers 341 and 342 may include, for example, an m-type 2D semiconductor material such as MoS₂, but example embodiments are not limited thereto. The third and fourth channel layers 341 and 342 may have a single-layer or multilayer structure.

A fifth gate 331 may be provided on an upper surface of the third channel layer 341, and a sixth gate 332 may be provided on an upper surface of the fourth channel layer 342. The fifth and sixth gates 331 and 332 may each extend in the second direction (x-axis direction). In other words, the fifth and sixth gates 331 and 332 may be provided perpendicular to the third and fourth gates 231 and 232 provided thereunder, in a plan view. As such, the fifth and sixth transistors Tr3a and Tr3b in the third tier T3 may be provided perpendicular to the third and fourth transistors Tr2a and Tr2b in the second tier T2, in a plan view. The fifth and sixth gates 331 and 332 may each include a metal material or a conductive oxide.

A source region of the third channel layer 341 may be formed between the fifth isolation layer 301 and the fifth gate 331, and a drain region of the third channel layer 341 may be formed between the sixth isolation layer 302 and the fifth gate 331. A first via 361 may be provided in a source region of the third channel layer 341, and the first via 361 may correspond to a source of the fifth transistor Tr3a.

As illustrated in FIG. 7A, the drain region of the third channel layer 341 may be electrically connected to the third metal line 261 through a third connection layer 291 formed in the second tier T2. The third connection layer 291 may correspond to a drain of the fifth transistor Tr3a. As such, a drain region of the fifth transistor Tr3a in the third tier T3 and the fourth gate 232 of the fourth transistor Tr2b in the second tier T2 may be electrically connected to each other through the third connection layer 291, the third metal line 261, and the fourth gate contact 232'.

A drain region of the fourth channel layer 342 may be formed between the fifth isolation layer 301 and the sixth gate 332, and a source region of the fourth channel layer 342 may be formed between the sixth isolation layer 302 and the sixth gate 332. A second via 362 may be provided in a source region of the fourth channel layer 342, and the second via 362 may correspond to a source of the sixth transistor Tr3b.

The drain region of the fourth channel layer 342 may be electrically connected to the fourth metal line 262 through a fourth connection layer (not shown) formed in the second tier T2. The fourth connection layer may correspond to a drain of the sixth transistor Tr3b. As such, a drain region of the sixth transistor Tr3b in the third tier T3 and the third gate 231 of the third transistor Tr2a in the second tier T2 may be electrically connected to each other through the fourth connection layer, the fourth metal line 262, and the third gate contact 231'.

Referring to FIGS. 5B, 7A, 7B, 11, and 12, a first conductive layer 371 and a third via 363 may be sequentially provided on an upper surface of the first via 361, and the first bit line BL1 may be provided on an upper surface of the third via 363. A second conductive layer 372 and a fourth via 364 may be sequentially provided on an upper surface of the second via 362, and a second bit line BL2 may be provided on an upper surface of the fourth via 364. The first and second bit lines BL1 and BL2 may extend in the first direction (y-axis direction). The word line WL may be provided above the fifth and sixth gates 331 and 332 and connected to the fifth and sixth gates 331 and 332 through the fifth and sixth gate contacts 331' and 332'. The word line WL may extend in the second direction (x-axis direction). A third insulating layer 350 may be provided in the third tier T3 to cover the fifth and sixth transistors Tr3a and Tr3b. The third and fourth channel layers 341 and 342 and the third and fourth gates 331 and 332 in the third tier T3 may be modified in various ways similar to the illustrations in FIGS. 8A to 8F.

As described above, the first metal line 161 in the first tier T1 may electrically connect the first source 111 of the first transistor Tr1a to the first drain 221 of the third transistor Tr2a. The third metal line 261 in the second tier T2 may electrically connect the drain region of the fifth transistor Tr3a to the fourth gate 232 of the fourth transistor Tr2b. The first and third metal lines 161 and 261 are electrically connected to each other to constitute a first interlayer insulating layer, and may be a wire to form a first node (Q node) illustrated in the circuit diagram of FIG. 1.

The second metal line 162 in the first tier T1 may electrically connect the second source 112 of the second transistor Tr1b to the second drain 222 of the fourth transistor Tr2b. The fourth metal line 262 in second tier T2 may electrically connect the drain region of the sixth transistor Tr3b to the third gate 231 of the third transistor Tr2a. The second and fourth metal lines 162 and 262 may be electrically connected to each other to constitute a second interlayer insulating layer, and may be a wire to form a second node (Qb node) illustrated in the circuit diagram of FIG. 1.

As described above, in an SRAM device according to some example embodiments, a memory cell has a monolithic 3D stack structure including three or more tiers, each tier including a pair of transistors. An inter-floor connection layer that electrically connect the transistors in different tiers is provided in the tiers, and by arranging a gate of a transistor (e.g., an access transistor) provided in a specific tier to be perpendicular to a gate of a transistor (e.g., a pull-up transistor or a pull-down transistor) provided in a different tier, in a plan view, area efficiency of a memory cell may be improved.

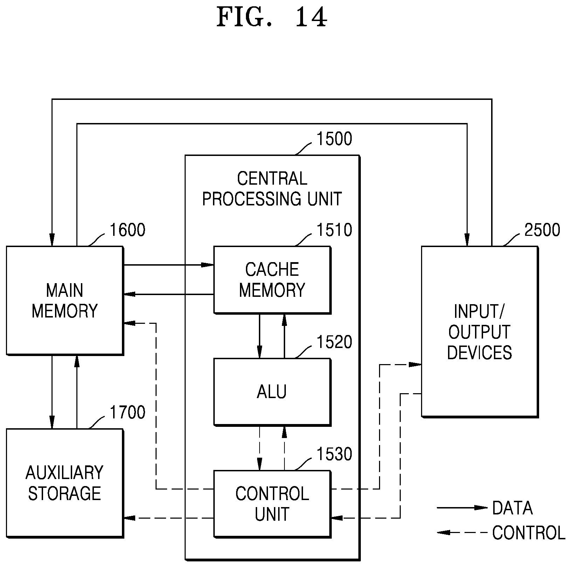

The SRAM device having a monolithic 3D stack structure, according to the embodiment described above may be applied to various electronic apparatuses. FIG. 14 is a schematic conceptual view of a device architecture applicable to an electronic apparatus according to some example embodiments.

Referring to FIG. 14, a cache memory 1510, an arithmetic logic unit (ALU) 1520, and a control unit 1530 may constitute a central processing unit (CPU) 1500, and the cache memory 1510 may include the SRAM device described above. Aside from the CPU 1500, a main memory 1600 and an auxiliary storage 1700 may be further provided. In some cases, the device architecture may be implemented in the form in which computing unit elements and memory unit elements are adjacent to each other in one chip without distinction of sub-units. Furthermore, in some cases, the device architecture may include an input/output device 2500.

Any of the elements and/or functional blocks disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components such as at least one of transistors, resistors, capacitors, etc. The processing circuitry may include electrical components such as logic gates including at least one of AND gates, OR gates, NAND gates, NOT gates, etc.

By having a design of an SRAM device including a stack of transistors, with the transistors including a two-dimensional material, integration density may be improved. Alternatively or additionally, electrical performance, such as speed and/or power consumption, may be improved. Alternatively or additionally, in some cases yield and/or reliability may be improved.

It should be understood that the SRAM device having a monolithic 3D stack structure described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims. Furthermore, example embodiments are not necessarily mutually exclusive with one another. For example, some example embodiments may include one or more features described with reference to one or more figures, and may also include one or more other features described with reference to one or more other figures.

## Claims

1. A static random-access memory, SRAM, device comprising:
a first tier comprising first and second transistors;
a second tier stacked on the first tier and comprising third and fourth transistors; and
a third tier stacked on the second tier and comprising fifth and sixth transistors,
wherein each of the first to sixth transistors comprises a channel layer including a two-dimensional semiconductor material, and
a gate of at least one of the fifth and sixth transistors intersects a gate of at least one of the first to fourth transistors.

2. The SRAM device of claim 1, wherein the first transistor and the third transistor are electrically connected to each other through a first metal line in the first tier, and the second transistor and the fourth transistor are electrically connected to each other through a second metal line in the first tier.

3. The SRAM device of claim 2, wherein the third transistor and the fifth transistor are electrically connected to each other through a third metal line in the second tier, and the fourth transistor and the sixth transistor are electrically connected to each other through a fourth metal line in the second tier.

4. The SRAM device of claim 3, wherein a drain region of the fifth transistor is electrically connected to a gate of the third transistor through the second metal line, and a drain region of the sixth transistor is electrically connected to a gate of the fourth transistor through the fourth metal line.

5. The SRAM device of claim 3 or 4, wherein a drain of the third transistor passes through a channel layer of the third transistor to connect the first and third metal lines to each other, and a drain of the fourth transistor passes through a channel layer of the fourth transistor to connect the second and fourth metal lines to each other.

6. The SRAM device of any preceding claim, wherein each of the first and second transistors comprises a PFET, and each of the third, fourth, fifth, and sixth transistors comprises an NFET.

7. The SRAM device of claim 6, wherein the channel layer of each of the first and second transistors comprises WSe₂, and the channel layer of each of the third, fourth, fifth, and sixth transistors comprises MoS₂.

8. The SRAM device of claim 6 or 7, wherein the first and third transistors correspond to a first CMOS invertor, and the second and fourth transistors correspond to a second CMOS invertor.

9. The SRAM device of claim 8, wherein each of the fifth and sixth transistors comprises an access transistor.

10. The SRAM device of any preceding claim, wherein at least one of the first to sixth transistors comprises a channel region of a single-layer structure and a channel layer including source and drain regions of a multilayer structure.

11. The SRAM device of any preceding claim, wherein at least one of the first to sixth transistors comprises first and second gates respectively provided above and under a corresponding channel layer.

12. The SRAM device of any preceding claim, wherein at least one of the first to sixth transistors comprises:
a plurality of channel layers arranged apart from each other; and
a gate surrounding the plurality of channel layers.

13. An electronic apparatus comprising the SRAM device of any preceding claim.
